Europäisches Patentamt

European Patent Office

Office européen des brevets

(11) Numéro de publication: **0 375 500**

**A1**

## (12) DEMANDE DE BREVET EUROPEEN

(21) Numéro de dépôt: **89403408.1**

(22) Date de dépôt: **08.12.89**

(51) Int. Cl.5: **H01L 21/28, H01L 21/339**

(30) Priorité: **20.12.88 FR 8816805**

(43) Date de publication de la demande:
**27.06.90 Bulletin 90/26**

(84) Etats contractants désignés:
**DE FR GB NL**

(71) Demandeur: **THOMSON COMPOSANTS MILITAIRES ET SPATIAUX**
**50, rue J.P. Timbaud**
**F-92400 Courbevoie(FR)**

(72) Inventeur: **Blanchard, Pierre .**
**THOMSON-CSF SCPI Cédex 67**
**F-92045 Paris La Défense(FR)**
Inventeur: **Baussand, Patrick**
**THOMSON-CSF SCPI Cédex 67**
**F-92045 Paris La Défense(FR)**

(74) Mandataire: **Guérin, Michel et al**
**THOMSON-CSF SCPI**
**F-92045 PARIS LA DEFENSE CEDEX 67(FR)**

(54) **Procédé de fabrication d'électrodes de faible dimension, dans un circuit intégré.**

(57) Elaboration d'électrodes très resserrées, notamment dans un dispositif à transfert de charge.

Selon l'invention, une première couche (11) de matériau conducteur est déposée et subit une gravure incomplète en présence d'un masque (13); après élimination du masque, une seconde couche de matériau conducteur est déposée et l'ensemble est soumis à une gravure sans masque, ce qui permet de réduire la largeur des espaces interélectrodes.

EP 0 375 500 A1

*FIG. 2*

## "Procédé de fabrication d'électrodes de faible dimension, dans un circuit intégré"

L'invention se rapporte à un procédé de fabrication d'électrodes dans un circuit intégré et concerne plus particulièrement l'élaboration de telles électrodes dans un dispositif à transfert de charge.

L'invention permet d'obtenir des électrodes ou grilles séparées par des intervalles aussi faibles que possible.

Dans un dispositif à transfert de charge, il est courant de définir les électrodes dans des couches de silicium polycristallin. Une telle couche est déposée sur un substrat isolant. On procède ensuite à une attaque de gravure au travers d'un masque définissant la configuration des électrodes. Un problème constant, dans la mise en oeuvre de ces techniques, est d'obtenir des configurations aux cotes voulues. Dans l'état actuel des choses, on peut considérer que les cotes sont respectées à la photolithographie définissant le masque, mais qu'en revanche, il y a retrait latéral à la gravure. Ce retrait est plus ou moins important suivant le mode de gravure utilisé. On distingue en effet la gravure dite isotrope où l'attaque du silicium s'opère de la même façon dans toutes les directions et la gravure dite anisotrope où il est possible de donner une certaine directivité à l'attaque de la couche de silicium en privilégiant l'attaque de la couche en profondeur. Quoi qu'il en soit, le retrait latéral est inévitable. Le problème est accentué par le fait que, dans les circuits actuels, on utilise un nombre de plus en plus important de niveaux d'électrodes, ce qui aboutit à une "topologie" des différentes couches de plus en plus complexe, des temps de gravure nécessairement plus grands et donc une surgravure de certaines couches, avec des retraits relativement importants. Il est possible, dans une certaine mesure, de précompenser une surgravure par les dessins des masques. Cependant, ce type de compensation est limité par la résolution photolithographique et il n'est plus applicable dans le cas de configurations très resserrées, notamment périodiques.

L'invention permet de résoudre ce problème et d'obtenir des électrodes très resserrées, notamment des configurations où des espaces interélectrodes peuvent être inférieurs à ce que permettrait la résolution photolithographique.

Dans cet esprit, l'invention concerne donc essentiellement un procédé de réalisation d'électrodes dans un circuit intégré, caractérisé en ce qu'il consiste principalement:

- à déposer une première couche de matériau conducteur,
- à déposer un masque sur ladite première couche pour définir une configuration d'électrodes,

- à soumettre cette couche recouverte dudit masque à une attaque de gravure,
- à interrompre cette attaque avant individualisation desdites électrodes,
- à éliminer ledit masque,
- à déposer une seconde couche de matériau conducteur sur ladite première couche incomplètement gravée, et
- à soumettre l'ensemble ainsi obtenu à une nouvelle attaque, en l'absence de masque, jusqu'à individualisation desdites électrodes.

Ainsi, l'invention est remarquable en ce qu'elle met en oeuvre un double dépôt et une double gravure mais n'utilise qu'un seul masque. Elle s'applique tout particulièrement pour la fabrication des électrodes dites "de stockage" d'un dispositif à transfert de charge, pour lesquelles il est souhaitable de réduire autant que faire se peut, la largeur des intervalles séparant les électrodes les unes des autres. Les deux attaques sont réalisées de préférence en mode anisotrope.

L'invention sera mieux comprise et d'autres avantages de celle-ci apparaîtront plus clairement à la lumière de la description qui va suivre d'un procédé conforme à son principe et de quelques variantes, donnée uniquement à titre d'exemple et faite en référence aux dessins annexés dans lesquels:

- les figures 1 à 4 illustrent les principales phases d'un procédé de formation d'électrodes conforme à l'invention;
- la figure 5 est une vue analogue à la figure 4 illustrant une variante; et
- les figures 6 et 7 illustrent des phases particulières d'une autre variante.

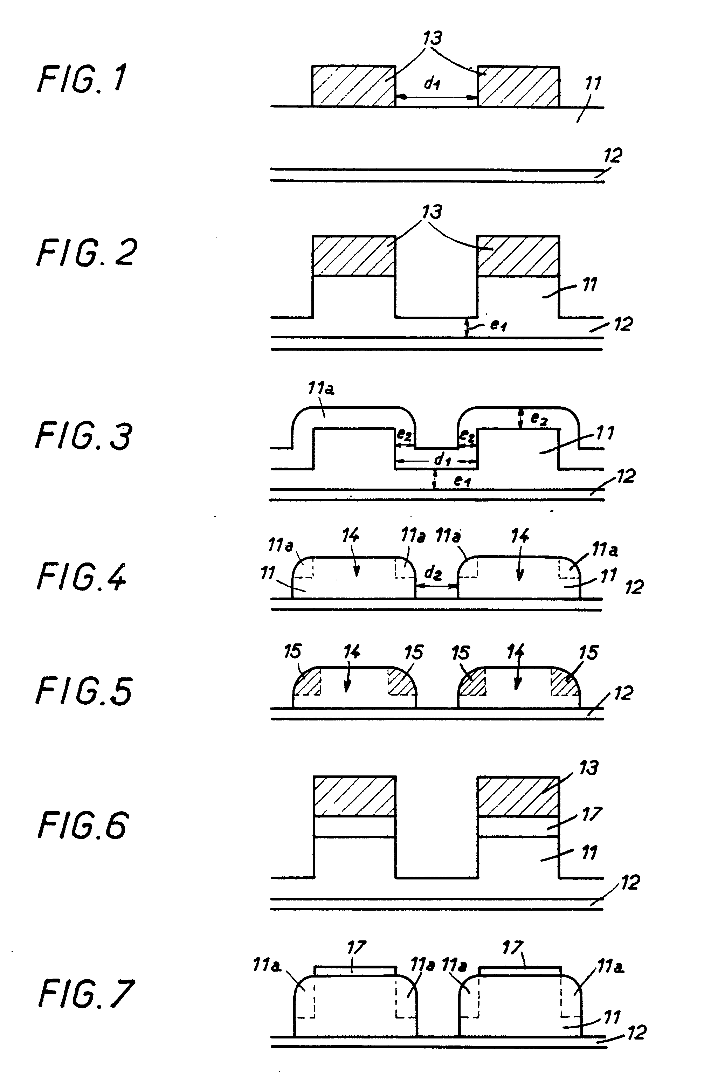

En considérant plus particulièrement les figures 1 à 4, on a illustré les étapes de formation des électrodes de stockage d'un dispositif à transfert de charge. Ces électrodes ou grilles sont, comme cela est habituel, réalisées en silicium polycristallin. Une première couche 11 de silicium polycristallin est d'abord déposée sur un substrat isolant 12, en oxyde de silicium. Un masque 13 est ensuite déposé sur la couche 11. C'est la situation illustrée à la figure 1. Il est à noter que les modes opératoires pour déposer les couches ou les masques sont classiques et ne seront pas décrits en détail; il en est de même pour les gravures ou attaques de ces couches et pour l'élimination du masque. Si on considère la figure 1, on peut admettre que, si nécessaire, l'espace $d_1$ laissé entre deux parties du masque destinées à préserver les futures électrodes est aussi réduit que le permet la résolution de la photolithographie utilisée pour l'élaboration dudit masque.

Selon une particularité importante de l'invention, on procède alors à une attaque de gravure, ici anisotrope, mais cette gravure n'est pas menée jusqu'à son terme, c'est-à-dire jusqu'à individualisation des électrodes. Autrement dit, on laisse subsister une certaine épaisseur $e_1$ de la couche de silicium 11 au fond des futurs espaces interélectrodes, le substrat 12 n'étant pas découvert à ce stade du procédé. C'est la situation illustrée à la figure 2. On rappelle que la profondeur de gravure est maîtrisée en contrôlant le temps pendant lequel la couche de silicium polycristallin est soumise à l'attaque de gravure. Le masque est ensuite éliminé et on procède au dépôt d'une seconde couche 11a de silicium polycristallin, d'épaisseur $e_2$, sur la première couche incomplètement gravée. On obtient ainsi la structure illustrée à la figure 3 où on voit que l'espace interélectrode qui était $d_1$ à la précédente gravure, est diminué d'environ deux fois l'épaisseur $e_2$ de la couche 11a. L'épaisseur de silicium aux emplacements des futurs espaces interélectrodes augmente et devient $e_1 + e_2$. On procède alors à une seconde attaque, en l'absence de masque, également du type anisotrope. Cette fois, l'attaque est poursuivie jusqu'à individualisation desdites électrodes. Autrement dit, l'attaque est prolongée jusqu'à ce qu'une épaisseur $e_1 + e_2$ de silicium ait disparu, ce qui a pour effet de dégager le substrat isolant au fond des espaces interélectrodes et donc de séparer ces dernières. Les électrodes 14 apparaissent sur la figure 4. Cependant, l'espace interélectrode $d_2$ reste plus faible que ce qu'il aurait été possible d'obtenir avec la photolithographie de la figure 1. Sur la figure 4, qui montre la structure obtenue à la fin du procédé, on voit que la deuxième couche 11a a presque totalement disparu sauf sur les bords des électrodes, l'espace interélectrode final $d_2$ étant plus faible que l'espace $d_1$ qui avait été défini par le masque.

Dans l'exemple décrit ci-dessus, les deux couches 11 et 11a sont en même matériau conducteur, en l'occurrence du silicium polycristallin, mais on peut concevoir des variantes avec des matériaux conducteurs différents. En particulier, si la première couche est en silicium polycristallin, ladite seconde couche peut être en un matériau propre à se combiner avec ledit silicium polycristallin pour former un siliciure à faible résistivité. Plus particulièrement, la seconde couche peut, dans ce cas, être un métal dit "réfractaire" tel que le tantale ou le titane. Le siliciure à faible résistivité est alors obtenu par un traitement thermique, connu en soi, intervenant après le dépôt de ladite seconde couche. Le résultat final est celui de la figure 5, analogue à l'état de la figure 4, mais où les zones latérales 15 sont, en fait, en siliciure très conducteur et non plus en silicium polycristallin, comme dans l'exemple précédent. Le traitement thermique peut intervenir immédiatement après l'étape de la figure 3 ou après la seconde attaque, c'est-à-dire sur une structure analogue à celle de la figure 4. Cette variante a l'avantage de réduire sensiblement les résistances d'accès des électrodes. Elle reste applicable pour la fabrication de dispositifs à transfert de charge optiques. En effet, la transparence est conservée dans la plus grande partie de la largeur de l'électrode puisque celle-ci est toujours en silicium polycristallin. Les parties latérales opaques en siliciure sont, de toutes façons, situées dans les zones de recouvrement inter-grille, qui sont déjà des zones ayant une topologie "perturbée", ce qui limite l'inconvénient de leur opacité.

Les figures 6 et 7 représentent les phases modifiées d'une variante; elles correspondent respectivement aux figures 2 et 4. Cette variante permet de conserver l'épaisseur de la première couche. Elle consiste à déposer une couche de protection 17 sur ladite première couche 11 de matériau conducteur, avant le dépôt du masque 13. Pour la première attaque de gravure, en présence du masque, les conditions d'attaque et/ou l'agent de gravure sont adaptées pour enlever successivement les parties de ladite couche de protection non recouvertes par le masque puis le silicium polycristallin situé dans les futurs espaces interélectrodes. A la seconde attaque anisotrope, la partie supérieure de l'électrode est protégée par les parties de la couche de protection qui étaient situées sous le masque. La couche de protection 17 peut être de l'oxyde de silicium. On aboutit alors à la structure représentée sur la figure 7 où les surfaces supérieures des électrodes sont recouvertes des restes de la couche de protection.

## Revendications

1- Procédé de réalisation d'électrodes dans un circuit intégré, caractérisé en ce qu'il consiste principalement:

- à déposer une première couche (11) de matériau conducteur,

- à déposer un masque (13) sur ladite première couche pour définir une configuration d'électrodes,

- à soumettre cette couche recouverte dudit masque à une attaque de gravure,

- à interrompre cette attaque avant individualisation desdites électrodes,

- à éliminer ledit masque,

- à déposer une seconde couche (11a) de matériau conducteur sur ladite première couche incomplètement gravée, et

- à soumettre l'ensemble ainsi obtenu à une nouvelle attaque, en l'absence de masque, jusqu'à individualisation desdites électrodes (14).

2- Procédé selon la revendication 1, caractérisé en ce que lesdites première (11) et seconde (11a) couches sont dans un même matériau conducteur, par exemple du silicium polycristallin.

3- Procédé selon la revendication 1, caractérisé en ce que lesdites première et seconde couches sont dans des matériaux conducteurs différents.

4- Procédé selon la revendication 3, caractérisé en ce que ladite première couche (11) est en silicium polycristallin et en ce que ladite seconde couche est en un matériau propre à se combiner avec ledit silicium polycristallin en formant un siliciure à faible résistivité (figure 5).

5- Procédé selon la revendication 4, caractérisé en ce qu'il comporte une phase de traitement thermique après le dépôt de ladite seconde couche, pour donner naissance audit siliciure.

6- Procédé selon une des revendications précédentes, caractérisé en ce qu'il consiste à déposer une couche de protection (17) sur ladite première couche (11) de matériau conducteur, avant le dépot dudit masque.

FIG.1

FIG.2

FIG.3

FIG.4

FIG.5

FIG.6

FIG.7

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | JOURNAL OF THE ELECTROCHEMICAL SOCIETY, vol. 130, no. 9, septembre 1983, pages 1894-1897, Manchester, New Hampshire, US; R.M. LEVIN et al.: "Oxide isolation for double-polysilicon VLSI devices" * Figure 1 * --- | 1,2,6 | H 01 L  21/28 H 01 L  21/339 |
| A | EP-A-0 142 186  (PHILIPS) * Figures 3-5,10; résumé * ----- | 1,4,5 | |

**DOMAINES TECHNIQUES RECHERCHES (Int. Cl.5)**

H 01 L

Le présent rapport a été établi pour toutes les revendications

| Lieu de la recherche | Date d'achèvement de la recherche | Examinateur |
|---|---|---|
| LA HAYE | 06-03-1990 | GELEBART J.F.M. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03.82 (P0402)